Europäisches Patentamt

European Patent Office

Office européen des brevets

(19)

(11) Veröffentlichungsnummer: **0 196 130**
**B1**

(12) # EUROPÄISCHE PATENTSCHRIFT

(45) Veröffentlichungstag der Patentschrift:
**18.07.90**

(51) Int. Cl.⁵: **H03J 5/24**

(21) Anmeldenummer: **86200361.3**

(22) Anmeldetag: **07.03.86**

(54) **Schaltungsanordnung der Eingangsstufen eines Fernsehtuners.**

(30) Priorität: **16.03.85 DE 3509516**

(43) Veröffentlichungstag der Anmeldung:
**01.10.86 Patentblatt 86/40**

(45) Bekanntmachung des Hinweises auf die Patenterteilung:
**18.07.90 Patentblatt 90/29**

(84) Benannte Vertragsstaaten:
**DE FR GB**

(56) Entgegenhaltungen:
**US-A- 3 794 924**
**US-A- 3 852 670**
**US-A- 4 326 295**
**US-A- 4 424 594**

(73) Patentinhaber: **Philips Patentverwaltung GmbH,
Wendenstrasse 35 Postfach 10 51 49,
D-2000 Hamburg 1(DE)**

(84) Benannte Vertragsstaaten: **DE**

(73) Patentinhaber: **N.V. Philips' Gloeilampenfabrieken,
Groenewoudseweg 1, NL-5621 BA Eindhoven(NL)**

(84) Benannte Vertragsstaaten: **FR GB**

(72) Erfinder: **Kupfer, Karl-Heinz, Krefelder Strasse 145,
D-4150 Krefeld 29(DE)**

(74) Vertreter: **Kupfermann, Fritz-Joachim, Dipl.-Ing. et al,
Philips Patentverwaltung GmbH
Wendenstrasse 35 Postfach 10 51 49,
D-2000 Hamburg 1(DE)**

EP 0 196 130 B1

## Beschreibung

Die Erfindung bezieht sich auf eine Schaltungsanordnung der Eingangsstufen eines Fernsehtuners nach dem Oberbegriff des Hauptanspruchs.

Bekannte Einganggstufen für Fernsehtuner weisen getrennte Primärbandfilter für UHF-Band und VHF-Band auf. Das Primärbandfilter des VHF-Bandes ist dabei durch Überbrücken einer Induktivität im Filter umschaltbar zwischen den Bändern I und III. Dem VHF-Primärbandfilter ist ein Tiefpaß, dessen Grenzfrequenz bei etwa 380 MHz liegt, vorgeschaltet. Diesem Tiefpaß und dem VHF-Primärbandfilter können weitere Filter zwischengeschaltet sein, z.B. ein ZF-Hochpaß. Dem Primärbandfilter des UHF-Bandes ist ein Hochpaß vorgeschaltet, dessen Grenzfrequenz bei etwa 400 MHz liegt. Durch den dem VHF-Primärbandfilter vorgeschalteten Tiefpaß und den dem UHF-Primärbandfilter vorgeschalteten Hochpaß wird das Antennensignal in zwei Frequenzbereiche aufgeteilt, wodurch die Verluste sehr gering gehalten werden, da der UHF-Frequenzbereich nur zum UHF-Primärbandfilter gelangt und vor dem VHF-Bandfilter gesperrt ist. Auf diese Weise tritt im VHF-Primärbandfilter kein UHF-Energieverlust ein. Entsprechendes gilt auch für den VHF-Frequenzbereich, der durch das dem UHF-Bandfilter vorgeschaltete Hochpaßfilter vor dem UHF-Primärbandfilter gesperrt wird, so daß dort keine Energieverluste im VHF-Frequenzbereich entstehen. Ein Tuner dieser Bauart ist beispielsweise der Philips-Tuner UV 618.

Aus der Entgegenhaltung US-A 4 424 594 ist ein Resonanzkreis für den Gebrauch in einem VHF-Fernsehempfangs-Abstimmsystem bekannt. Darin ist ein Parallelresonanzkreis enthalten mit einem Varaktor und zwei Parallelzweigen mit Induktivitäten, die durch Diodenschalter teilweise überbrückt und teilweise abgetrennt werden können. Zur Erhöhung der oberen Frequenzgrenze des Abstimmbereichs wird in der Entgegenhaltung US-A 4 424 594 die Lehre gegeben, die ohmschen Verluste des Varaktors durch spezielle Wahl seiner Bauart, beispielsweise als Galliumarsenid-Varaktordiode, zu erniedrigen. Eine Anregung für eine Verringerung der Energieverluste, die durch die Aufteilung des Antennensignals auf verschiedene, parallelgeschaltete Filter entstehen, wird in der Entgegenhaltung US-A 4 424 594 nicht gegeben.

Es ist Aufgabe der Erfindung in einer Schaltungsanordnung eines Fernsehtuners neben den Eingangsstufen für die Frequenzbänder UHF und VHF zusätzlich eine Eingangsstufe für das Hyperband zu schaffen, wobei möglichst geringe Verluste in allen Frequenzbändern auftreten sollen.

Die gestellte Aufgabe ist erfindungsgemäß durch die Merkmale im kennzeichnenden Teil des Hauptanspruchs gelöst.

Diese Schaltungsanordnung bietet bei Einsatz weniger zusätzlicher Bauelemente eine Integration des Hyperbandteils bei gleichzeitig einfachem Aufbau der Schaltung. Da außerdem die Primärbandfilter für Hyperband und VHF-Band einen gemeinsamen Ausgang haben, ist eine einfache Ankopplung einer gemeinsamen nachfolgenden Verstärkerstufe möglich. Bei einer parallelen Anordnung dreier paralleler Bandfilter für VHF-, UHF- und Hyperband wäre es kaum möglich, vor den Bandfiltern die Antennenenergie nur dem jeweiligen Primärbandfilter zuzuführen, so daß in den anderen Filtern Verluste auftreten. Da das Hyperband frequenzmäßig zwischen dem VHF-Band und dem UHF-Band angeordnet ist, würden insbesondere im Primärbandfilter des Hyperbandes VHF- und UHF-Energieverluste auftreten, was nur durch den Einsatz einer Schaltdiode vor dem Hyperbandfilter verhindert werden könnte. Die Schaltungsanordnung nach der Erfindung umgeht diese Probleme dadurch, daß das Hyperband-Primärbandfilter in das VHF-Primärbandfilter integriert wird und so kein drittes, parallel angeordnetes Filter notwendig wird. Es treten hier ähnlich geringe UHF-Energieverluste im VHF-Hyperband-Primärbandfilter auf, wie im VHF-Primärbandfilter nach dem Stand der Technik.

Nach einer weiteren Ausgestaltung der Erfindung ist vorgesehen, daß eine weitere Induktivität zwischen die vierte und die dritte Induktivität geschaltet ist und daß der Verbindungspunkt zwischen der vierten und der weiteren Induktivität den Eingang des Primärbandfilters für VHF- und Hyperband bildet. Dadurch werden weitere Anpassungsmöglichkeiten des Primärbandfilters geschaffen.

Nach einer weiteren Ausgestaltung der Erfindung ist vorgesehen, daß dem Antenneneingang eine Gleichstrom-Ableitung nachgeschaltet ist.

Diese Ableitung evtl. auftretender Gleichströme kann z.B. durch eine gegen Masse geschaltete Induktivität vorgenommen werden.

Nach weiteren Ausgestaltungen der Erfindung sind dem VHF-und Hyperband-Primärbandfilter ein ZF-Hochpaß, eine ZF-Sperre, eine UKW-Sperre oder eine CB-Sperre vorgeschaltet.

Da dem VHF- und Hyperband-Primärbandfilter kein Hochpaß vorgeschaltet ist, kann es angebracht sein, weitere Sperren bzw. Filter dem Primärbandfilter vorzuschalten. Selbstverständlich können auch mehrere dieser Filter hintereinander vor dem Primärbandfilter angeordnet werden.

Zwei Ausführungsformen der Erfindung werden anhand der Zeichnungen näher erläutert. Es zeigt:

Fig. 1 eine Schaltungsanordnung der Eingangsstufen für die Frequenzbänder UHF- und VHF-Band nach dem Stand der Technik,

Fig. 2 eine erste Ausführungsform der Schaltungsanordnung der Eingangsstufen für die Frequenzbereiche UHF-, VHF- und Hyperband nach der Erfindung,

Fig. 3 eine zweite Ausführungsform der Schaltungsanordnung der Eingangsstufen für die Frequenzbänder UHF-, VHF- und Hyperband nach der Erfindung.

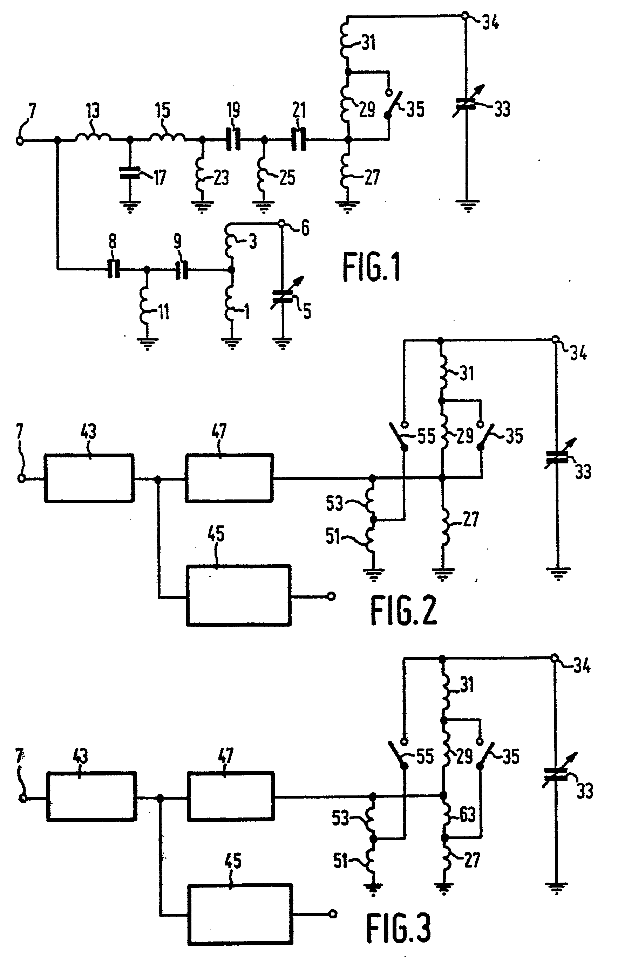

In Fig. 1 ist zur Verdeutlichung des zu lösenden Schaltungsproblems zunächst eine Schaltungsanordnung nach dem Stand der Technik dargestellt mit zwei parallel angeordneten Primärbandfiltern für den UHF-Bereich und den VHF-Bereich. Das UHF-Primärbandfilter besteht aus der Reihenschaltung zweier Induktivitäten 1 und 3 und einer veränderbaren Kapazität 5, deren erster Anschluß mit Masse verbunden ist und deren zweiter Anschluß den Ausgang 6 des VHF-Bandfilters darstellt. Zwischen dem Antenneneingang 7 und dem UHF-Primärbandfilter ist ein Hochpaß angeordnet, der über zwei in Reihe geschaltete Kondensatoren 8 und 9, von deren Verbindungspunkt eine Induktivität 11 gegen Masse führt, zum Verbindungspunkt der Induktivitäten 1 und 3 des UHF-Primärbandfilters führt. Ebenfalls vom Antenneneingang führt ein Tiefpaß, der aus zwei in Reihe geschalteten Induktivitäten 13, 15, von deren Verbindungspunkt eine Kapazität 17 gegen Masse führt, und ein nachgeschalteter Hochpaß, der mit zwei in Reihe geschalteten Kapazitäten 19 und 21, einer vor der Kapazität 19 gegen Masse führenden Induktivität 23 und einer vor der Kapazität 21 gegen Masse führenden Induktivität 25 aufgebaut ist, zum Eingang des VHF-Primärbandfilters. Von diesem Eingang führt eine Induktivität 27 gegen Masse und zwei weitere, in Reihe geschaltete Induktivitäten 29 und 31 zu einer veränderbaren Kapazität 33, die gegen Masse geschaltet ist und den Ausgang 34 des VHF-Primärbandfilters darstellt. Die Induktivität 29 kann mittels eines Schalters 35, der z. B. durch eine Schaltdiode ausgeführt sein kann, überbrückt werden. Dieser Schalter 35 dient der Umschaltung zwischen den Bereichen I und III des VHF-Bandes.

Ausgehend von diesem Stand der Technik zeigt Fig. 2 die erste Ausführungsform der Schaltungsanordnung nach der Erfindung. Dem Antenneneingang 7 ist eine Gleichstromableitung 43 nachgeschaltet. Hinter dieser Gleichstromableitung ist zum einen das UHF-Primärbandfilter 45, das in bekannter Weise aufgebaut ist, und zum zweiten über evtl. zwischengeschaltete Filter 47 das VHF- und Hyperband-Primärbandfilter angeordnet. Das VHF-Primärbandfilter, bestehend aus den Induktivitäten 27, 29, 31, der veränderbaren Kapazität 33 und dem Schalter 35 ist wie das oben beschriebene bekannte VHF-Primärbandfilter aufgebaut. Das in das VHF-Primärbandfilter integrierte Hyperband-Primärbandfilter besteht aus zwei vom Verbindungspunkt der Induktivitäten 27 und 29 in Reihe geschaltete und gegen Masse führende Induktivitäten 53 und 51 und aus einem Schalter 55, der vom Verbindungspunkt der Induktivitäten 51 und 53 zum Verbindungspunkt zwischen der Induktivität 31 und der veränderbaren Kapazität 33 führt. Bei VHF-Betrieb ist der Schalter 55 geöffnet; die parallel zu der Induktivität 27 liegenden Induktivitäten 51 und 53 sind relativ groß gegen die Induktivität 27, können aber trotzdem bei der Dimensionierung dieser entsprechend berücksichtigt werden. Bei Hyperbandbetrieb muß der Schalter 35 geöffnet, der Schalter 55 geschlossen sein. Das Hyperband-Primärbandfilter ist dann gebildet durch die Reihenschaltung der Induktivität 51 und der Kapazität 33, wobei eine Einkopplung des Signals über die Induktivität 53 auf den Verbindungspunkt zwischen Induktivität 51 und Kapazität 33 vorgenommen wird. Es liegen in diesem Falle parallel zu der Induktivität 51 die Induktivitäten 27, 29 und 31 in Reihe. Da die Reihenschaltung dieser Induktivitäten eine sehr viel größere Induktivität bildet als die Induktivität 51, fallen sie kaum ins Gewicht.

Bei dieser Schaltungsanordnung müssen also für die Umschaltung zwischen den Bereichen I und III des VHF-Bandes und dem Hyperband lediglich die Schalter 35 und 55, die z. B. durch Schaltdioden ausgeführt sein können, entsprechend geschaltet sein.

Fig. 3 zeigt die zweite Ausführungsform der Schaltungsanordnung nach der Erfindung. Zwischen die Induktivitäten 29 und 27 ist hier eine weitere Induktivität 63 geschaltet. Die Induktivitäten 29 und 63, deren Verbindungspunkt den Eingang des Primärbandfilters darstellt, können mittels des Schalters 35 überbrückt werden. Diese zweite Ausführungsform bietet andere Anpassungsmöglichkeiten, ist jedoch in ihrer Grundfunktion identisch mit der ersten Ausführungsform der Erfindung.

Bei beiden Ausführungsformen der Schaltungsanordnung ist eine äußerst einfache und bauteilsparende Integration des Hyperbandbereiches in das VHF-Primärbandfilter gegeben. Bestehende Schaltungskonzepte für Fernsehtuner, die für Empfang im VHF- und UHF-Bereich ausgelegt sind, müssen lediglich geringfügig verändert werden.

**Patentansprüche**

1. Schaltungsanordnung der Eingangsstufen eines Fernsehtuners für die Frequenzbänder UHF-, VHF- und Hyperband in einem durchgehenden Frequenzbereich eines Antennensignals, die hinter dem Antenneneingang parallelgeschaltete Primärbandfilter für UHF-Band und VHF-Band aufweist, wobei das VHF-Primärbandfilter an seinem Eingang mindestens in Reihe zum Ausgang geschaltete vierte und fünfte Induktivitäten (29 und 31), eine am Ausgang (34) angeordnete, gegen Masse geschaltete und veränderbare Kapazität (33) und einen ersten Schalter (35) aufweist, der die vierte Induktivität (29) überbrückt und der Umschaltung zwischen den BI- und BIII-Bereichen des VHF-Bandes dient, und wobei in das VHF-Primärbandfilter ein Hyperband-Primärbandfilter integriert ist, das eine zweite Induktivität (51) aufweist, die über einen zweiten Schalter (55) mit dem Ausgang (34) verbunden ist und mit ihrem anderen Anschluß gegen Masse führt, dadurch gekennzeichnet, daß das VHF-Primärbandfilter an seinem Eingang eine gegen Masse geschaltete dritte Induktivität (27) und eine erste Induktivität (53) aufweist, die mit dem Verbindungspunkt zwischen der zweiten Induktivität (51) und dem zweiten Schalter (55) einerseits und dem eingangsseitigen Anschluß der dritten Induktivität (27) andererseits verbunden ist, wobei für Hyperbandbetrieb der zweite Schalter (55) geschlossen und der erste Schalter (35) geöffnet ist.

2. Schaltungsanordnung nach Anspruch 1, dadurch gekennzeichnet, daß eine weitere Induktivität (63) zwischen die vierte und dritte Induktivität (29 und 27) geschaltet ist und daß der Verbindungspunkt zwischen der vierten und der weiteren Induktivität (29 und 63) den Eingang des Primärbandfilters für VHF- und Hyperband bildet.

3. Schaltungsanordnung nach den Ansprüchen 1 und 2,
dadurch gekennzeichnet, daß dem Antenneneingang eine Gleichstromableitung (43) nachgeschaltet ist.

4. Schaltungsanordnung nach einem der Ansprüche 1 bis 3,
dadurch gekennzeichnet, daß dem VHF- und Hyperband-Primärbandfilter ein ZF-Hochpaß vorgeschaltet ist.

5. Schaltungsanordnung nach einem der Ansprüche 1 bis 4,
dadurch gekennzeichnet, daß dem VHF- und Hyperband-Primärbandfilter eine ZF-Sperre vorgeschaltet ist.

6. Schaltungsanordnung nach einem der Ansprüche 1 bis 5,
dadurch gekennzeichnet, daß dem VHF- und Hyperband-Primärbandfilter eine UKW-Sperre vorgeschaltet ist.

7. Schaltungsanordnung nach einem der Ansprüche 1 bis 6,
dadurch gekennzeichnet, daß dem VHF- und Hyperband-Primärbandfilter eine CB-Sperre vorgeschaltet ist.

**Claims**

1. A circuit arrangement for the input stages of a television tuner for the UHF, VHF and hyperband frequency bands in a continuous frequency range of an aerial signal, comprising primary bandpass filters for the UHF and VHF bands arranged in parallel behind the aerial input, the VHF primary bandpass filter comprising at its input at least fourth and fifth inductances (29 and 31) arranged in series with the output, a grounded, variable capacitor (33) arranged at the output (34) and a first switch (35) shunting the fourth inductance (29) and used for switching over between the BI and BIII ranges of the VHF band, a hyperband primary bandpass filter being integrated in the VHF primary bandpass filter, comprising a second inductance (51) which is coupled via a second switch (55) to the output (34) and whose other terminal is connected to ground, characterized in that the VHF primary bandpass filter comprises at its input a grounded third inductance (27) and a first inductance (53) which is coupled to the junction between the second inductance (51) and the second switch (55) on the one side and the input-sided terminal at the third inductance (27) on the other side, the second switch (55) being closed and the first switch (35) being open for hyperband operation.

2. A circuit arrangement as claimed in Claim 1, characterized in that a further inductance (63) is arranged between the fourth and third inductances (29 and 27) and in that the junction between the fourth and further inductances (29 and 63) constitutes the input of the primary bandpass filter for the VHF band and hyperband.

3. A circuit arrangement as claimed in Claims 1 and 2, characterized in that a d.c. shunt (43) is arranged subsequent to the aerial input.

4. A circuit arrangement as claimed in any one of Claims 1 to 3, characterized in that an IF high-pass filter precedes the VHF and hyperband primary bandpass filters.

5. A circuit arrangement as claimed in any one of Claims 1 to 4, characterized in that an IF trap filter precedes the VHF and hyperband primary bandpass filters.

6. A circuit arrangement as claimed in any one of Claims 1 to 5, characterized in that a VHF trap filter precedes the VHF and hyperband primary bandpass filters.

7. A circuit arrangement as claimed in any one of Claims 1 to 6, characterized in that a CB trap filter precedes the VHF and hyperband primary bandpass filters.

**Revendications**

1. Montage de circuit des étages d'entrée d'un bloc d'accord de télévision pour les bandes de fréquence UHF, VHF et hyperbande dans un domaine de fréquences continu d'un signal d'antenne, qui comporte en aval de l'entrée d'antenne des filtres de bandes primaires connectés en parallèle pour la bande UHF et la bande VHF, dans lequel le filtre de bande primaire VHF comporte, à son entrée, au moins une quatrième et une cinquième inductance (29 et 31) connectées en série à la sortie, un condensateur variable (33) disposé à la sortie (34) et connecté à la masse et un premier commutateur (35), qui ponte la quatrième inductance (29) et sert à assurer la commutation entre les domaines BI et BIII de la bande VHF, et dans lequel, dans le filtre de bande primaire VHF, est intégré un filtre de bande primaire pour hyperbande qui comporte une deuxième inductance (51) qui est connectée à la sortie (34) par l'intermédiaire d'un deuxième commutateur (55) et est mise à la masse par son autre borne, caractérisé en ce que le filtre de bande primaire VHF comporte, à son entrée, une troisième inductance (27) mise à la masse et une première inductance (53) qui est connectée, d'une part, au point de jonction entre la deuxième inductance (51) et le deuxième commutateur (55) et, d'autre part, à la borne d'entrée de la troisième inductance (27), étant entendu que pour le mode hyperbande, le deuxième commutateur (55) est fermé et le premier commutateur (35) est ouvert.

2. Montage de circuit suivant la revendication 1, caractérisé en ce qu'une autre inductance (63) est connectée la quatrième et la troisième inductance (29 et 27) et que le point de jonction entre la quatrième inductance et cette autre inductance (29 et 63) forme l'entrée du filtre de bande primaire pour la bande VHF et l'hyperbande.

3. Montage de circuit suivant les revendications 1 et 2, caractérisé en ce qu'une dérivation de courant continu (43) est connectée en aval de l'entrée d'antenne.

4. Montage de circuit suivant l'une quelconque des revendications 1 à 3, caractérisé en ce qu'un filtre passe-haut FI est connecté en amont du filtre de bande primaire pour la bande VHF et l'hyperbande.

5. Montage de circuit suivant l'une quelconque des revendications 1 à 4, caractérisé en ce qu'un suppresseur FI est connecté en amont du filtre de bande primaire pour la bande VHF et l'hyperbande.

6. Montage de circuit suivant l'une quelconque des revendications 1 à 5, caractérisé en ce qu'un suppresseur FM est connecté en amont du filtre de bande primaire pour la bande VHF et l'hyperbande.

7. Montage de circuit suivant l'une quelconque des revendications 1 à 6, caractérisé en ce qu'un suppresseur CB est connecté en amont du filtre de bande primaire pour la bande VHF et l'hyperbande.

FIG.1

FIG.2

FIG.3